# EUROPEAN PATENT SPECIFICATION

(11) **EP 1 425 949 B1**
(45) Date of publication and mention of the grant of the patent: **08.03.2006**
(21) Application number: 02732644.6
(22) Date of filing: 22.04.2002
(51) Int. Cl.: H05K 3/28

(54) **PRINTED CIRCUIT BOARD**
LEITERPLATTE
CARTE DE CIRCUIT IMPRIME

(30) Priority: 04.05.2001 DE 10121673
(43) Date of publication of application: 09.06.2004
(73) Proprietor: Thomson Licensing, 92100 Boulogne Billancourt (FR)
(72) Inventor: HIRT, Hermann, 78050 Villingen-Schwenningen (DE); HEINI, Hubert, 78052 Villingen-Schwenningen (DE); WAGNER, Paul-Heinz, 78050 Villingen-Schwenningen (DE)
(74) Representative: Rossmanith, Manfred
(86) International application number: PCT/EP2002/004382
(87) International publication number: WO 2002/091810

(56) References cited:
- EP-A- 0 805 615
- DE-A- 2 312 482
- US-A- 5 090 120
- US-A- 5 304 392
- US-A- 5 316 894
- US-B1- 6 210 746
- "CONFORMAL COATING MATERIALS" ELECTRONIC PACKAGING AND PRODUCTION, CAHNERS PUBLISHING CO, NEWTON, MASSACHUSETTS, US, vol. 36, no. 2, 1 February 1996 (1996-02-01), pages 33-34, XP000557175 ISSN: 0013-4945
- 30395: "THERMOCOMPRESSION BONDED HIGH DENSITY CABLE DESIGN" RESEARCH DISCLOSURE, KENNETH MASON PUBLICATIONS, HAMPSHIRE, GB, no. 303, 1 July 1989 (1989-07-01), page 546 XP000045872 ISSN: 0374-4353
- DATABASE WPI Week 197906 Derwent Publications Ltd., London, GB; AN 1979-11115b XP002211295 -& JP 53 149673 A (MATSUSHITA ELEC IND CO) , 27 December 1978 (1978-12-27)

## Description

The invention is based on a printed circuit board according to the precharacterizing clause of Claim 1.

In electrical equipment with electronic circuits, for example in consumer electronics equipment such as television receivers, video recorders, hi-fi systems and in commercial equipment for telecommunications, what are known as printed circuit boards are predominantly used for realizing electric circuits. These comprise a base plate or support plate made of plastic, on one surface or on both surfaces of which conductor tracks consisting of copper with a thickness of up to 100 µm are applied by an etching process. The components are then soldered onto these conductor tracks at soldering areas.

In US 5,090,120 a process of forming solder lands on this type of circuit boards is disclosed. In the known process solder resist is filled between the conductor tracks to achieve a planar surface of the printed circuit board. The solder lands are then defined by a subsequent screen printing step.

Printed circuit boards of this type are also being used increasingly in motor vehicles, especially since the number of electric loads and necessary electrical connections in motor vehicles is constantly increasing. In a motor vehicle, such a printed circuit board has to meet special requirements. On the one hand, one of the requirements in a motor vehicle is that high currents of several amperes also have to be processed. On the other hand, printed circuit boards in a motor vehicle are subjected to increased environmental influences, such as for example moisture and mechanical loads. These requirements cannot always be adequately satisfied by previously known printed circuit boards.

EP 0 805 615 A2 a thick layer printed circuit board is disclosed with conductor tracks having a thickness of up to 400 µm. To protect the conductor tracks against adverse weather conditions, they are covered with a dielectric layer.

The invention is based on the object of providing a printed circuit board having a planar surface, being suitable for relatively high currents and being resistant to environmental influences such as moisture and the like.

This object is achieved by the invention specified in Claim 1. Advantageous embodiments of the invention are specified in the subclaims.

According to the invention, the thickness of the conductor tracks is made appreciably greater than 100 µm, and the intermediate spaces between the conductor tracks are filled with a filling material which has greatest possible adhesion to the conductor tracks, to the base plate and to the solder resist mask applied to the arrangement, being filled in such a way that the printed circuit board has a substantially planar surface without interruptions or depressions.

Several advantages are achieved by the solution according to the invention. The greater thickness of the conductor tracks in comparison with previously known printed circuit boards makes it possible for higher currents of up to several amperes to be processed. Filling the intermediate spaces between the conductor tracks, the planar surface brought about in this way and the good adhesion and edge coverage achieved have the effect that environmental influences, such as moisture in particular, on the printed circuit board are avoided to the greatest extent. The printed circuit board designed according to the invention has good stability and resistance. It is particularly well suited for what is known as the SMT (surface mount technology) method. At the same time, copper plating or lamination with copper foil is also possible in an advantageous way. The properties achieved therefore make the printed circuit board according to the invention particularly suitable for use in motor vehicles.

The filling material between the conductors may be formed in particular by a one- or two-component UV-curing lacquer, a two-component thermally curing plastic, a one-component thermally curing plastic, a primer together with a filling material, an acrylic resin, an epoxy resin or materials with similar chemical and mechanical properties.

In one embodiment of the invention, the thickness of the conductor tracks is of the order of magnitude of 400-1000 µm. Solutions of this type are also referred to as thick-copper printed circuit boards. The thickness of the conductor tracks is preferably dimensioned to be of such a size that it takes up the greater part of the thickness of the printed circuit board as a whole. Consequently, in the case of this solution, the stability of the printed circuit board as a whole is essentially no longer formed primarily by the base plate, as before, but by the thicker conductor tracks and the filling material arranged in between.

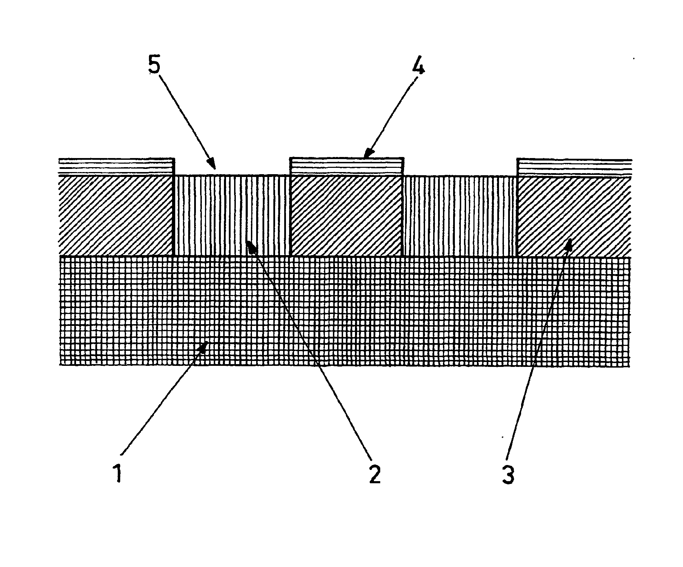

The invention is explained in more detail below on the basis of an exemplary embodiment, with reference to the drawing. In the drawing, the single figure shows a section through a printed circuit board designed according to the invention.

The figure shows the base plate 1 consisting of an insulating material. The conductor tracks 2 of copper, which have a thickness in the range of 100-400 µm, are applied to the base plate 1. The intermediate spaces between the conductor tracks 2 are filled by a filling material 3 with a thickness in the range of 100-400 µm. The printed circuit board consequently forms a planar surface on the base plate, without the intermediate spaces previously produced between the conductor tracks. The printed circuit board formed in this way is covered by what is known as a solder resist mask 4, with a thickness in the range of 14-20 µm. The soldered connection of individual components to the conductor tracks 2 takes place at the soldering areas 5.

The filling material 3 consists of one of the materials mentioned above or of a material with a similar electrical or mechanical behaviour. A material of this type achieves good adhesion of the filling material 3 to the conductor tracks 2, to the base plate 1 and to the solder resist mask 4 and also satisfactory edge coverage. As a result, environmental influences, such as moisture in particular, on the printed circuit board are avoided to the greatest extent. As the figure shows, the thickness of the conductor tracks 2 takes up a significant part of the thickness of the printed circuit board as a whole. The actual mechanical stability of the printed circuit board is consequently not primarily formed by the base plate 1, as before, but by the thicker-formed conductor tracks 2 and the filling material 3 arranged in between.

## Claims

1. Printed circuit board with a base plate (1) of insulating material, conductor tracks (2) arranged thereon and intermediate spaces between the conductor tracks (2), wherein the thickness of the conductor tracks (2) is greater than 100 µm, wherein the intermediate spaces between the conductor tracks (2) are completely filled with a filling material (3) adhering to the conductor tracks (2) and to the base plate (1), wherein the thickness of the filling material (3) is equal to the thickness of the conductor track, such that the printed circuit board has a planar surface, **characterized in that** the mechanical and chemical properties of the filling material (3) are different from those of material used for making a solder resist layer (4), and that the filling material is selected from the group including a one- or two-component thermally curing plastic, a one- or two-component UV-curing lacquer, an acrylic resin, and an epoxy resin.

2. Printed circuit board according to Claim 1, **characterized in that** the thickness of the conductor tracks (2) is dimensioned to be such that the filling material between the conductor tracks contributes appreciably to the mechanical stability of the printed circuit board, in particular **in that** it takes up the greater part of the thickness of the printed circuit board as a whole.

3. Printed circuit board according to Claim 1, **characterized in that** the thickness of a solder resist mask (4) that is applied onto the planar surface is in the range of 14 to 20 µm.

## Patentansprüche

1. Gedruckte Leiterplatte mit einer Basisplatte (1) aus Isoliermaterial, darauf aufgebrachten gedruckten Leiterbahnen (2) und Zwischenräumen zwischen den Leiterbahnen (2), wobei die Dicke der Leiterbahnen (2) größer ist als 100 µm, und wobei die Zwischenräume zwischen den Leiterbahnen (2) mit einem an den Leiterbahnen (2) und an der Basisplatte (1) haftenden Füllmaterial (3) vollständig gefüllt sind, wobei die Dicke des Füllmaterials (3) der Dicke der Leiterbahnen entspricht, so dass die Leiterplatte eine ebene Oberfläche aufweist, **dadurch gekennzeichnet, dass** die mechanischen und chemischen Eigenschaften des Füllmaterials (3) sich von denen eines Materials zur Herstellung einer Lötstoppmaske (4) unterscheiden, und dass das Füllmaterial aus einer Gruppe beinhaltend Ein- oder Zweikomponenten thermisch aushärtenden Kunststoff, Ein- oder Zweikomponenten UV-aushärtenden Lack, Acrylatharz und Epoxydharz ausgewählt ist.

2. Gedruckte Leiterplatte nach Anspruch 1, **dadurch gekennzeichnet, dass** die Dicke der Leiterbahnen (2) so bemessen ist, dass das Füllmaterial zwischen den Leiterbahnen wesentlich zu der mechanischen Stabilität der gedruckten Leiterplatte beiträgt, insbesondere dass die Dicke der Leiterbahnen den größten Teil der Dicke der gesamten gedruckten Leiterplatte einnimmt.

3. Gedruckte Leiterplatte nach Anspruch 1, **dadurch gekennzeichnet, dass** die Dicke einer auf die ebene Oberfläche aufgebrachten Lötstoppmaske (4) in der Größenordnung von 14-20 µm liegt.

## Revendications

1. Carte de circuit imprimé avec une plaque de base (1) en matériau isolant, des pistes conductrices (2) placées dessus et des espaces intermédiaires entres les pistes conductrices (2), dans laquelle l'épaisseur des pistes conductrices (2) est supérieure à 100 µm, dans laquelle les espaces intermédiaires entres les pistes conductrices (2) sont complètement remplis de matériau de remplissage (3) adhérant aux pistes conductrices (2) et à la plaque de base (1), dans laquelle l'épaisseur du matériau de remplissage (3) est égale à l'épaisseur de la piste conductrice, de sorte que la carte de circuit imprimé présente une surface planaire, **caractérisée en ce que** les propriétés mécaniques et chimiques du matériau de remplissage (3) sont différentes de celles du matériau utilisé pour réaliser une couche d'épargne de soudage (4), et **en ce que** le matériau de remplissage est sélectionné dans le groupe incluant un plastique à séchage thermique à un ou deux composants, une laque séchant sous UV à un ou deux composants, une résine acrylique et une résine époxyde.

2. Carte de circuit imprimé selon la Revendication 1, **caractérisée en ce que** l'épaisseur des pistes conductrices (2) est dimensionnée pour être telle que le matériau de remplissage entre les pistes conductrices contribue sensiblement à la stabilité mécanique de la carte de circuit imprimé, en particulier **en ce qu'**elle occupe la plus grande partie de l'épaisseur de la carte de circuit imprimé dans son ensemble.

3. Carte de circuit imprimé selon la Revendication 1, **caractérisée en ce que** l'épaisseur d'une couche d'épargne de soudage (4) qui est appliquée sur la surface planaire est située dans la plage de 14 à 20 µm.
